# EUROPEAN PATENT APPLICATION

(11) **EP 4 529 377 A1**
(43) Date of publication of application: **26.03.2025**
(21) Application number: 24195776.0
(22) Date of filing: 22.08.2024
(51) Int. Cl.: H05K 7/20

(54) **INVERTER AND PHOTOVOLTAIC ENERGY STORAGE SYSTEM**

(30) Priority: 20.09.2023 CN 202311224654
(71) Applicant: Huawei Digital Power Technologies Co., Ltd., Shenzhen, 518043 (CN)
(72) Inventor: YANG, Gun, Shenzhen, 518043 (CN); YAN, Weijia, Shenzhen, 518043 (CN); YAN, Yang, Shenzhen, 518043 (CN); SONG, Weiping, Shenzhen, 518043 (CN)
(74) Representative: Isarpatent

(57) **Abstract**

This application provides an inverter and a photovoltaic energy storage system. The inverter includes a plurality of power devices, a chassis, and a partition and blocking assembly, where the plurality of power devices and the partition and blocking assembly are accommodated in a cavity of the chassis. The partition and blocking assembly divides the cavity of the chassis into two installation cavities, and the plurality of power devices are disposed in the two installation cavities. The chassis includes a first side wall and a second side wall that are adjacent to each other. An air inlet of a fan of the partition and blocking assembly communicates with one installation cavity, an air outlet of the fan communicates with the other installation cavity, and a direction from the air inlet to the air outlet faces away from the first side wall. A gap exists between the partition and blocking assembly and the second side wall, or the partition and blocking assembly is provided with a through hole. In the inverter, one fan is disposed, so that a circulation air duct that flows through all power devices may be formed between the two installation cavities. This can reduce a size of the inverter when heat dissipation performance of the inverter is ensured, to improve convenience of transportation and installation of the inverter, and helps reduce costs of a photovoltaic energy storage system in which the inverter is used.

## Description

### TECHNICAL FIELD

This application relates to the field of heat dissipation technologies, and in particular, to an inverter and a photovoltaic energy storage system.

### BACKGROUND

As power of an inverter increases, there are more power devices inside a chassis of the inverter. Because a power device generates a large amount of heat in a working process, a plurality of fans are disposed in the inverter to cool each power device and a chassis cavity, for ensuring normal running of each power device. As a result, the chassis of the inverter is relatively large in size, and the entire inverter is relatively heavy. This is unfavorable to installation and transportation of the inverter.

Therefore, how to reduce the size of the inverter when effective heat dissipation of the power device inside the chassis is implemented becomes an urgent technical problem to be resolved currently.

### SUMMARY

This application provides an inverter and a photovoltaic energy storage system, to reduce a size and a weight of the inverter when heat dissipation performance of the inverter is ensured, so that convenience of transportation and installation of the inverter is improved.

According to a first aspect, this application provides an inverter. The inverter may include a plurality of power devices, a chassis, and a partition and blocking assembly, where the plurality of power devices and the partition and blocking assembly are accommodated in a cavity of the chassis. The partition and blocking assembly divides the cavity of the chassis into a first installation cavity and a second installation cavity that are of different sizes, where a volume of the first installation cavity is less than a volume of the second installation cavity, and in this case, a part of power devices in the plurality of power devices are disposed in the first installation cavity, and the other part of power devices in the plurality of power devices are disposed in the second installation cavity. In addition, the chassis includes a first side wall and a second side wall that are adjacent to each other, the partition and blocking assembly includes a fan, an air inlet of the fan communicates with the first installation cavity, an air outlet of the fan communicates with the second installation cavity, and a direction from the air inlet to the air outlet faces away from the first side wall. A gap exists between the partition and blocking assembly and the second side wall, or the partition and blocking assembly is provided with a through hole. In the inverter provided in this application, one fan is disposed, so that air in the first installation cavity flows to the second installation cavity along the direction from the air inlet to the air outlet of the fan, and air in the second installation cavity flows back to the first installation cavity through the gap between the partition and blocking assembly and the second side wall or through the through hole of the partition and blocking assembly. In this way, an air duct that flows through all power devices can be formed between the first installation cavity and the second installation cavity. This can help reduce a size and a weight of the inverter when a heat dissipation requirement of each power device is met, so that convenience of transportation and installation of the inverter is improved.

In a possible implementation of this application, the partition and blocking assembly further includes a first baffle and a second baffle, the first baffle and the second baffle are respectively disposed at two opposite ends of a housing of the fan, and the first baffle and the second baffle abut against the housing of the fan. In this way, the first baffle, the fan, and the second baffle may be connected to form a partition and blocking structure, so that after the fan is started, the first baffle and the second baffle implement a function of blocking airflow, that is, a function of controlling a flowing direction of air. In this way, air in the first installation cavity flows along the direction from the air inlet to the air outlet of the fan as much as possible. This helps improve circulation efficiency of air in the cavity of the chassis, to help improve heat dissipation efficiency of the inverter.

In specific disposing of the first baffle and the second baffle, the first baffle and the first side wall may be disposed opposite to each other. An included angle between the second baffle and the first side wall in a counterclockwise direction is greater than or equal to 90° and less than or equal to 180°. In this case, the first baffle and the second baffle may be disposed based on an internal layout of the cavity of the chassis of the inverter, so that disposing of the partition and blocking assembly may be relatively flexible.

In a possible implementation of this application, the first baffle and the second baffle may be disposed perpendicular to each other, to help reduce the volume of the first installation cavity. This helps improve a flowing speed of air in the first installation cavity, to help improve a flowing speed of air in the cavity of the chassis and help improve heat dissipation efficiency of the inverter.

In addition, based on a layout situation of each power device in the second installation cavity of the chassis, the first baffle and the second baffle may alternatively be disposed in parallel. In this way, sizes of the first baffle and the second baffle may be adjusted, to adjust a position of the fan relative to each power device in the second installation cavity, so that air blown out of the air outlet of the fan can flow through all power devices in the second installation cavity to a greater extent. This helps improve heat dissipation efficiency of each power device in the second installation cavity, to help improve heat dissipation efficiency of the inverter.

In a possible implementation of this application, the chassis further includes a third side wall, the second side wall, the first side wall, and the third side wall are sequentially connected, and the second side wall and the third side wall are disposed opposite to each other. In addition, when the first baffle and the second baffle are perpendicular to each other, an end that is of the second baffle and that faces away from the fan abuts against the first side wall. Alternatively, when the first baffle and the second baffle are in parallel, an end that is of the second baffle and that faces away from the fan abuts against the third side wall. This helps improve effect of controlling a flowing direction of air by the second baffle, to help improve a flowing speed of air in the first installation cavity.

In the foregoing implementation, the partition and blocking assembly may include two baffles. In a possible implementation of this application, the partition and blocking assembly may include one baffle. For example, the partition and blocking assembly includes the first baffle. In addition, the chassis further includes the third side wall, the second side wall, the first side wall, and the third side wall are sequentially connected, and the second side wall and the third side wall are disposed opposite to each other. In this case, the first baffle and the first side wall may be disposed opposite to each other, the housing of the fan abuts against the third side wall of the chassis, and the first baffle abuts against the housing of the fan. The partition and blocking assembly adopts the foregoing structure design, so that a structure of the partition and blocking assembly can be simplified. This helps simplify a structure of the inverter.

In a possible implementation of this application, when the gap exists between the partition and blocking assembly and the second side wall, the gap may be located between the second side wall and an end that is of the first baffle and that faces away from the fan, to form an air return vent between the first baffle and the second side wall. In this way, air in the second installation cavity can flow back to the first installation cavity through the gap.

In addition, when the partition and blocking assembly is provided with the through hole, the through hole may be provided on the first baffle. In this case, the through hole may be used as the air return vent, and air in the second installation cavity may flow back to the first installation cavity through the through hole.

In a possible implementation of this application, a projection of the first baffle onto the first side wall covers projections of the part of power devices in the first installation cavity onto the first side wall. In this way, air that flows back from the second installation cavity to the first installation cavity can flow through all power devices in the first installation cavity. This helps improve heat dissipation efficiency of the power device in the first installation cavity, to improve heat dissipation efficiency of the inverter.

In a possible implementation of this application, the inverter further includes a first circuit board, the first circuit board and the first side wall are disposed in parallel, and the part of power devices may be disposed on a side that is of the first circuit board and that faces the first baffle. In this way, the part of power devices may be disposed close to the first baffle, so that low-temperature air that flows back from the second installation cavity to the first installation cavity may first flow through the part of power devices. This helps improve heat dissipation efficiency of the part of power devices.

In another possible implementation of this application, the inverter includes a second circuit board, the second circuit board and the first side wall are disposed perpendicular to each other, the second circuit board is located between the first side wall and the first baffle, and the part of power devices are disposed on the second circuit board. This may help reduce a spacing between the first side wall and the first baffle, to help reduce the volume of the first installation cavity, so that a flowing speed of air in the first installation cavity is improved, to improve heat dissipation efficiency of the part of power devices.

In a possible implementation of this application, a largest spacing between the part of power devices and the first baffle is less than or equal to a first spacing threshold. The first spacing threshold may be specifically set based on a specific heat dissipation requirement of the inverter, a layout of the cavity of the chassis, and the like. In this design, a spacing between the part of power devices and the first baffle can be as small as possible, so that a spacing between the first side wall and the first baffle is as small as possible. Air in the first installation cavity mainly flows between the first baffle and the first side wall. In this case, a relatively small spacing between the first side wall and the first baffle helps improve an amount and a flowing speed of air flowing through the part of power devices. This helps improve heat dissipation efficiency of the part of power devices.

In a possible implementation of this application, a largest spacing between the fan and the first side wall is less than or equal to a smallest spacing between the first baffle and the first side wall. In this way, one passage that gradually narrows along a flowing direction of air can be formed in the first installation cavity. This helps improve a flowing speed of air in the first installation cavity, so that heat dissipation efficiency of the part of power devices in the first installation cavity can be improved, and circulation efficiency of air in the cavity of the chassis is improved.

In a possible implementation of this application, the first baffle includes a bent portion and a blocking portion that are connected, the blocking portion and the first side wall are disposed opposite to each other, the bent portion extends along a direction from the blocking portion to the first side wall, and an end that is of the bent portion and that faces away from the blocking portion abuts against the housing of the fan, so that the gradually narrowed passage is formed in the first installation cavity. In this way, a spacing between the blocking portion and the first side wall may be greater than a spacing between the fan and the first side wall, so that a width of a part that is of the air duct in the first installation cavity and that is located between the blocking portion and the first side wall is greater than a width of a part that is of the air duct and that is located between the fan and the first side wall.

In a possible implementation of this application, a projection of the air outlet of the fan onto the first side wall covers projections of the other part of power devices onto the first side wall. In this way, air blown out of the air outlet of the fan can flow through the other part of power devices in the second installation cavity to a greater extent, to help improve heat dissipation efficiency of each power device in the second installation cavity. This helps improve heat dissipation efficiency of the inverter.

In a possible implementation of this application, the chassis further includes a top wall and a bottom wall. The top wall and the bottom wall are disposed opposite to each other, and the housing of the fan abuts against the bottom wall. In addition, a largest spacing between the partition and blocking assembly and the top wall is less than or equal to a second spacing threshold, where the second spacing threshold may be specifically set based on a specific heat dissipation requirement of the inverter, a layout of the cavity of the chassis, and the like. Adoption of this design helps air in the first installation cavity to flow to the second installation cavity through the fan, and helps air in the second installation cavity to flow back to the first installation cavity through the gap between the partition and blocking assembly and the second side wall or through the through hole of the partition and blocking assembly, so that a directional airflow passage can be formed in the cavity of the chassis. This helps improve circulation efficiency of air in the cavity of the chassis, to improve heat dissipation efficiency of the inverter.

In a possible implementation of this application, the part of power devices disposed in the first installation cavity and the other part of power devices disposed in the second installation cavity are power devices with highest heat generation efficiency in the inverter. For example, the part of power devices may include an electrolytic capacitor, the other part of power devices may include an inductor and a relay, and the part of power devices and the other part of power devices may alternatively include another power device with highest heat generation efficiency. This is not limited herein. Efficient heat dissipation is performed on the power device with the highest heat generation efficiency in the inverter, to effectively improve heat dissipation efficiency of the entire inverter.

According to a second aspect, this application further provides a photovoltaic energy storage system. The photovoltaic energy storage system may include an energy storage system and the inverter in the first aspect. A direct current input end of the inverter is configured to connect to the photovoltaic module, and an alternating current output end of the inverter is connected to an alternating current output end of the energy storage system and a load. Because a size and a weight of the inverter of the photovoltaic energy storage system are relatively small, transportation and installation of the inverter is convenient. This helps control costs of the photovoltaic energy storage system.

### BRIEF DESCRIPTION OF DRAWINGS

FIG. 1 is a diagram of a three-dimensional structure of a chassis of an inverter according to an embodiment of this application;
FIG. 2 is a simple diagram of a conventional structure of an inverter according to an embodiment of this application;
FIG. 3 is a simple diagram of a structure of an inverter according to an embodiment of this application;
FIG. 4 is a simple diagram of another structure of an inverter according to an embodiment of this application;
FIG. 5 is a simple diagram of another structure of an inverter according to an embodiment of this application;
FIG. 6 is a simple diagram of another structure of an inverter according to an embodiment of this application;
FIG. 7 is a simple diagram of another structure of an inverter according to an embodiment of this application;
FIG. 8 is a simple diagram of another structure of an inverter according to an embodiment of this application;
FIG. 9 is a simple diagram of another structure of an inverter according to an embodiment of this application;
FIG. 10 is a simple diagram of another structure of an inverter according to an embodiment of this application; and
FIG. 11 is a simple diagram of another structure of an inverter according to an embodiment of this application.

### Reference numerals:

1: inverter; 101: chassis; 1011a: first installation cavity; 1011b: second installation cavity;
10111: air inlet gap; 1012a: first side wall; 1012b: second side wall; 1012c: third side wall; 1012d: fourth side wall; 1013: top wall;
1014: bottom wall; 102: partition and blocking assembly; 1021: first baffle; 10211: through hole; 10212: bent portion; 10213: blocking portion;
1022: second baffle; 1023: fan; 10231: air inlet; 10232: air outlet; 103: first circuit board; 104: third circuit board;
105: electrolytic capacitor; 106: relay; 107: inductor; 108: stud; 109: second circuit board; 110: direct current switch.

### DESCRIPTION OF EMBODIMENTS

To make the objectives, technical solutions, and advantages of this application clearer, the following further describes this application in detail with reference to the accompanying drawings. However, example implementations may be implemented in a plurality of forms, and should not be construed as being limited to implementations described herein. Identical reference numerals in the accompanying drawings indicate identical or similar structures. Therefore, repeated description thereof is omitted. Expressions of positions and directions in embodiments of this application are described by using the accompanying drawings as an example. However, changes may be also made as required, and all the changes fall within the protection scope of this application. The accompanying drawings in embodiments of this application are merely used to illustrate relative position relationships and do not represent an actual scale.

It should be noted that specific details are set forth in the following description to facilitate understanding of this application. However, this application can be implemented in a plurality of manners different from those described herein, and a person skilled in the art can make similar inferences without departing from the connotation of this application. Therefore, this application is not limited to the specific implementations disclosed below.

To facilitate understanding of the inverter and the photovoltaic energy storage system provided in this application, an application scenario of the inverter and the photovoltaic energy storage system is first described. The photovoltaic energy storage system is a system that uses photovoltaic effect of a semiconductor material to convert solar energy into electric energy and store the electric energy. The photovoltaic energy storage system may usually include a photovoltaic module, an inverter, and an energy storage system. The photovoltaic module may be configured to convert solar energy into electric energy, and a direct current input end of the inverter is configured to connect to the photovoltaic module. In addition, an alternating current output end of the inverter is connected to an alternating current output end of the energy storage system and a load, where the load may be an electric device or a power grid. In this case, the inverter may be configured to perform power conversion on a current of a direct current from the photovoltaic module, or may be configured to perform power conversion on a voltage of a direct current from the photovoltaic module, so that power output by the inverter matches power of the energy storage system and the load.

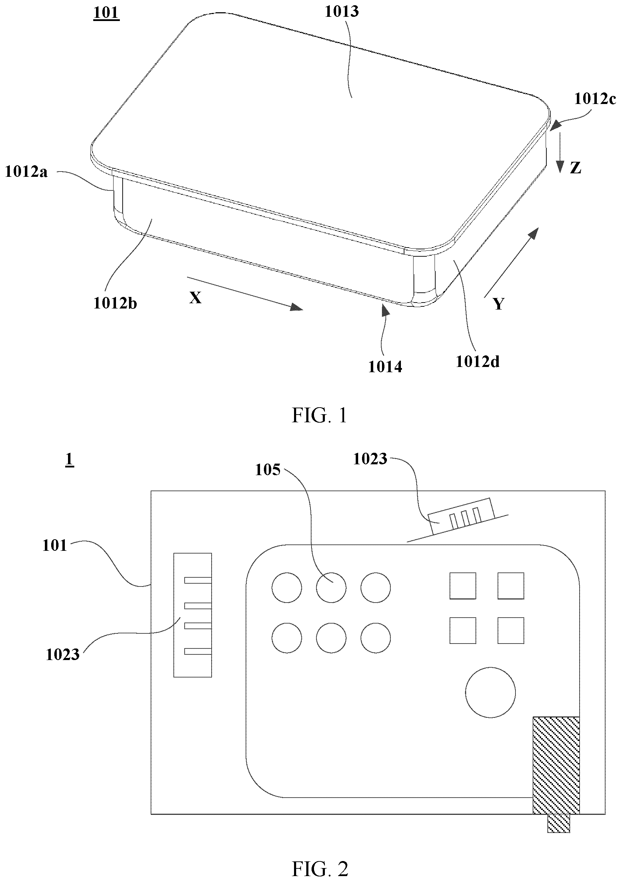

FIG. 1 is a diagram of a three-dimensional structure of a chassis of an inverter according to an embodiment of this application. In this application, a specific shape of the chassis 101 of the inverter is not limited. For example, the chassis 101 may be a cube shown in FIG. 1. In this case, the chassis 101 may include a top wall 1013, a bottom wall 1014, and four side walls. When the inverter is in normal use, the bottom wall 1014 is configured to support the entire inverter, and the top wall 1013 and the bottom wall 1014 are disposed opposite to each other. In addition, the four side walls include a first side wall 1012a and a fourth side wall 1012d that are disposed opposite to each other, and a second side wall 1012b and a third side wall 1012c that are disposed opposite to each other. For ease of description, as shown in FIG. 1, an arrangement direction from the first side wall 1012a to the fourth side wall 1012d of the chassis 101 may be defined as an X direction, an arrangement direction from the second side wall 1012b to the third side wall 1012c may be defined as a Y direction, and a direction from the top wall 1013 to the bottom wall 1014 may be defined as a Z direction.

A plurality of power devices, such as an inductor, an electrolytic capacitor, or a relay, are usually disposed in the chassis of the inverter. These power devices generate a large amount of heat in a working process. If heat dissipation cannot be performed on these power devices in time, performance of the power devices is affected. FIG. 2 is a simple diagram of a conventional structure of an inverter according to an embodiment of this application, and can show a view of the inverter along the Z direction. Currently, the inverter 1 uses a plurality of fans 1023 disposed in the chassis 101 to cool each power device and a cavity of the chassis 101. As a result, both a size and a weight of the inverter 1 are relatively large. This is unfavorable to installation and transportation of the inverter 1.

In addition, because power of the current inverter 1 increases, a size of a power device such as an electrolytic capacitor 105 in the inverter 1 also increases. If these power devices are still disposed on a same circuit board, a size of the chassis 101 of the inverter 1 increases along the Z direction, and another area of the cavity of the chassis 101 cannot be fully used, resulting in relatively low space utilization of the cavity of the chassis 101. In some current inverters 1, a plurality of power devices are disposed across circuit boards, to solve this problem. In other words, the plurality of power devices are disposed on different circuit boards. For example, an electrolytic capacitor is disposed on one circuit board, and another power device is disposed on another circuit board. In this way, circuit boards on which different power devices are disposed may be flexibly arranged based on layout space of the cavity of the chassis 101 of the inverter 1. For example, two circuit boards may be arranged in directions perpendicular to each other, to improve area utilization of the cavity of the chassis 101. However, after the plurality of power devices are disposed on different circuit boards, a plurality of fans 1023 still need to be disposed in the cavity of the chassis 101 of the inverter 1, to ensure heat dissipation effect of each power device. This still causes the size and the weight of the inverter 1 to be relatively large, consequently affecting convenience of transportation and installation of the inverter 1.

In view of this, a partition and blocking assembly is disposed in the inverter provided in embodiments of this application, to control a flowing direction of air, so that all power devices are located in a same air duct. In this way, only one fan may be disposed in the inverter to implement heat dissipation of each power device and the cavity of the chassis of the inverter. This helps reduce the size and the weight of the inverter, facilitates transportation and installation of the inverter, and can reduce costs of a photovoltaic energy storage system in which the inverter is used. The following specifically describes the inverter provided in embodiments of this application with reference to the accompanying drawings.

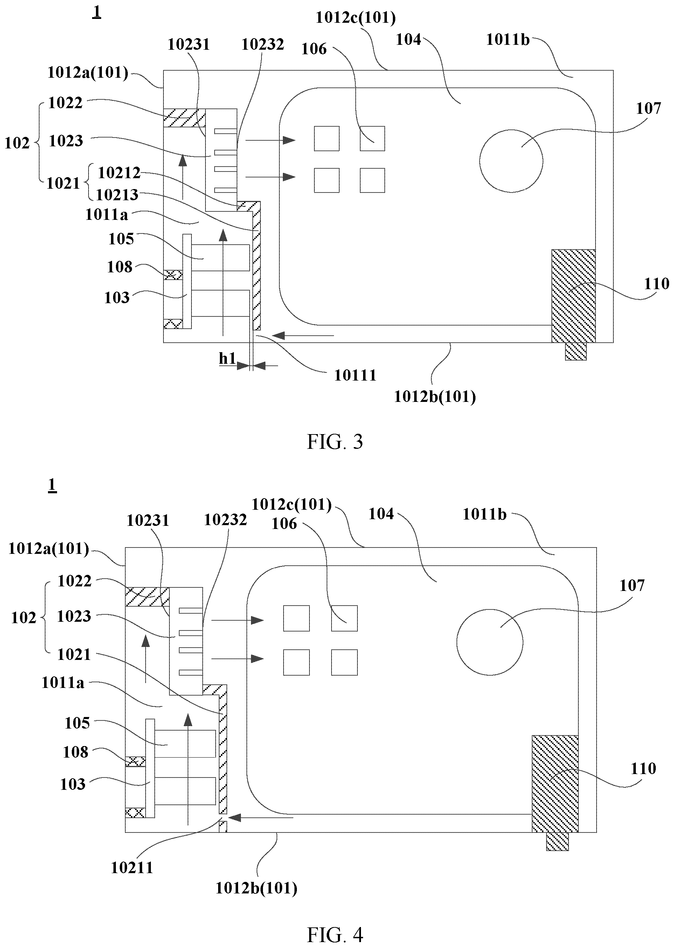

FIG. 3 is a simple diagram of a structure of an inverter 1 according to an embodiment of this application. FIG. 3 shows a view of the inverter 1 in the Z direction shown in FIG. 1. The inverter 1 provided in this embodiment of this application includes a partition and blocking assembly 102. The partition and blocking assembly 102 divides the cavity of the chassis 101 into two installation cavities. A part of power devices in the plurality of power devices of the inverter 1 may be disposed in one installation cavity, and the other part of power devices in the plurality of power devices of the inverter 1 may be disposed in the other installation cavity. In this embodiment of this application, for ease of description, the two installation cavities may be respectively denoted as a first installation cavity 1011a and a second installation cavity 1011b, where a volume of the first installation cavity 1011a is less than a volume of the second installation cavity 1011b. In this case, a part of power devices in the plurality of power devices may be disposed in the first installation cavity 1011a, and the other part of power devices in the plurality of power devices may be disposed in the second installation cavity 1011b.

In this application, the part of power devices disposed in the first installation cavity 1011a and the other part of power devices disposed in the second installation cavity 1011b are power devices with highest heat generation efficiency in the inverter 1. For example, in the inverter 1 shown in FIG. 3, the electrolytic capacitor 105 is disposed in the first installation cavity 1011a. In addition, the electrolytic capacitor 105 may be disposed on a first circuit board 103 . In this case, the first circuit board 103 is also disposed in the first installation cavity 1011a. Other power devices such as a relay 106, an inductor 107, and the like, and a third circuit board 104 for disposing these power devices are disposed in the second installation cavity 1011b. In addition, in the inverter 1 shown in FIG. 3, the first circuit board 103 and the third circuit board 104 are disposed perpendicular to each other, the first circuit board 103 may be fastened to the first side wall 1012a of the chassis 101 through a fastener such as a stud 108, and the third circuit board 104 may be fastened to the bottom wall 1014 of the chassis 101.

In specific disposing of the partition and blocking assembly 102, as shown in FIG. 3, the partition and blocking assembly 102 includes two baffles. In this application, for ease of description, the two baffles may be respectively denoted as a first baffle 1021 and a second baffle 1022. The first baffle 1021 and the second baffle 1022 are disposed at a specified included angle. An angle value of the included angle between the first baffle 1021 and the second baffle 1022 is not specifically limited in this application. For example, in the inverter 1 shown in FIG. 3, the first baffle 1021 and the second baffle 1022 may be disposed perpendicular to each other.

In addition, the partition and blocking assembly 102 further includes the fan 1023, where the fan 1023 may be configured to circulate air between the first installation cavity 1011a and the second installation cavity 1011b. During specific implementation, in the inverter 1 shown in FIG. 3, the first baffle 1021 and the second baffle 1022 may be respectively disposed at two opposite ends of the fan 1023, to prevent the first baffle 1021 and the second baffle 1022 from blocking an air inlet 10231 and an air outlet 10232 of the fan 1023. This helps improve working efficiency of the fan 1023. In addition, the air inlet 10231 of the fan 1023 communicates with the first installation cavity 1011a, the air outlet 10232 of the fan 1023 communicates with the second installation cavity 1011b, and a direction from the air inlet 10231 to the air outlet 10232 of the fan 1023 faces away from the first side wall 1012a of the chassis 101. In this case, in a working process of the fan 1023, after flowing through the first circuit board 103 disposed in the first installation cavity 1011a and the power device disposed on the first circuit board 103, air enters the fan 1023 through the air inlet 10231, and then blows to the second installation cavity 1011b through the air outlet 10232. In this way, heat dissipation of power devices disposed on different circuit boards and the cavity of the chassis 101 is implemented through drawing and blowing of the fan 1023.

In addition, in the inverter 1 shown in FIG. 3, the first baffle 1021 and the second baffle 1022 may be disposed perpendicular to each other. This helps reduce the volume of the first installation cavity 1011a, to improve a flowing speed of air in the first installation cavity 1011a. In this way, a flowing speed of air in the cavity of the chassis 101 is improved, to help improve heat dissipation efficiency of the inverter 1.

In addition, as shown in FIG. 3, an end that is of the second baffle 1022 and that faces away from the fan 1023 abuts against the first side wall 1012a of the chassis 101. This helps improve effect of controlling a flowing direction of air by the second baffle 1022, to help improve a flowing speed of air in the first installation cavity 1011a. In addition, an end that is of the second baffle 1022 and that faces the top wall 1013 may abut against the top wall 1013, and an end that is of the second baffle 1022 and that faces the bottom wall 1014 may also abut against the bottom wall 1014. In this way, all other ends of the second baffle 1022 other than the end connected to the fan 1023 abut against the chassis 101, to further improve a function of blocking, by the second baffle 1022, a flowing direction of air flowing through the first installation cavity 1011a. This helps improve heat dissipation effect of the inverter 1. In addition, in this application, the second baffle 1022 may be further fastened to the first side wall 1012a of the chassis 101 at an abutting position in a manner such as welding, riveting, bonding, or the like, to improve structural reliability of the inverter 1.

It may be understood that the first installation cavity 1011a communicates with the second installation cavity 1011b, so that air in the cavity of the chassis 101 circulates between the first installation cavity 1011a and the second installation cavity 1011b. During specific implementation, an end that is of the first baffle 1021 and that is away from the fan 1023 and the second side wall 1012b of the chassis 101 are spaced, so that a gap 10111 is formed between the first baffle 1021 and the second side wall 1012b of the chassis 101. In other words, the gap 10111 is formed between the partition and blocking assembly 102 and the second side wall 1012b. The second side wall 1012b and the first side wall 1012a are adjacently disposed. In this case, a flowing direction of air in the cavity of the chassis 101 may be represented by an arrow in FIG. 3. In other words, air enters the second installation cavity 1011b after flowing through the first installation cavity 1011a, and then flows from the second installation cavity 1011b to the first installation cavity 1011a through the gap 10111, so that a circulation air duct may be formed in the cavity of the chassis 101.

It should be noted that, in this application, in addition to forming the gap 10111 between the first baffle 1021 and the second side wall 1012b to implement communication between the first installation cavity 1011a and the second installation cavity 1011b, the two areas may alternatively be communicated in another possible manner. For example, in an inverter 1 shown in FIG. 4, the partition and blocking assembly 102 may be provided with a through hole 10211, and the through hole 10211 may be provided on the first baffle 1021. In this case, air in the second installation cavity 1011b may flow to the first installation cavity 1011a through the through hole 10211.

The inverter 1 shown in FIG. 3 is still used as an example. In the inverter 1 provided in this application, a projection of the first baffle 1021 onto the first side wall 1012a of the chassis 101 covers a projection of the first circuit board 103 onto the first side wall 1012a, and the projection of the first baffle 1021 onto the first side wall 1012a of the chassis 101 covers projections of the part of power devices in the plurality of power devices disposed in the first installation cavity 1011a onto the first side wall 1012a. In this way, air that flows back from the second installation cavity 1011b to the first installation cavity 1011a may flow through all power devices in the first installation cavity 1011a. This helps improve heat dissipation efficiency of each power device on the first circuit board 103 disposed in the first installation cavity 1011a, to help improve heat dissipation effect of the entire inverter 1.

Still refer to FIG. 3. The first circuit board 103 and the first side wall 1012a of the chassis 101 are disposed in parallel, and the part of power devices disposed in the first installation cavity 1011a are disposed on a side that is of the first circuit board 103 and that faces the first baffle 1021. For example, the electrolytic capacitor 105 is disposed on a surface that is of the first circuit board 103 and that faces the first baffle 1021. In this way, the part of power devices may be disposed close to the first baffle 1021, so that low-temperature air that flows back from the second installation cavity 1011b to the first installation cavity 1011a may first flow through the part of power devices. This helps improve heat dissipation efficiency of the part of power devices.

In addition, in the inverter 1 shown in FIG. 3, a length direction of the electrolytic capacitor 105 may be perpendicular to the first circuit board 103. In this way, the electrolytic capacitor 105 may be prevented from occupying space of the chassis 101 along the Z direction. This helps reduce the size of the chassis 101 and the volume of the first installation cavity 1011a, to help improve heat dissipation efficiency of the electrolytic capacitor 105.

In the inverter 1 provided in this application, a largest spacing h1 between the part of power devices and the first baffle 1021 may be further less than or equal to a first spacing threshold. The first spacing threshold may be specifically set based on a specific heat dissipation requirement of the inverter 1, a layout of the cavity of the chassis 101, and the like. In this design, a spacing between the part of power devices and the first baffle 1021 can be as small as possible, so that a spacing between the first side wall 1012a and the first baffle 1021 is as small as possible. Air in the first installation cavity 1011a mainly flows between the first baffle 1021 and the first side wall 1012a. In this case, a relatively small spacing between the first side wall 1012a and the first baffle 1021 helps improve an amount and a flowing speed of air flowing through the part of power devices. This helps improve heat dissipation efficiency of the part of power devices.

Still refer to FIG. 3. The first baffle 1021 may further include a bent portion 10212 and a blocking portion 10213 that are connected. The blocking portion 10213 and the first side wall 1012a are disposed opposite to each other, the bent portion 10212 extends along a direction from the blocking portion 10213 to the first side wall 1012a, and an end that is of the bent portion 10212 and that faces away from the blocking portion 10213 abuts against a housing of the fan 1023. In this way, a spacing between the blocking portion 10213 and the first side wall 1012a may be greater than a spacing between the fan 1023 and the first side wall 1012a, so that a width of a part that is of the air duct in the first installation cavity 1011a and that is located between the blocking portion 10213 and the first side wall 1012a is greater than a width of a part that is of the air duct and that is located between the fan 1023 and the first side wall 1012a. In this way, a passage that gradually narrows along a flowing direction of air is formed in the first installation cavity 1011a. This helps improve a flowing speed of air in the first installation cavity 1011a, so that heat dissipation efficiency of the part of power devices in the first installation cavity 1011a can be improved, and circulation efficiency of air in the cavity of the chassis 101 can be improved.

It should be noted that, a right-angle bent structure may exist between the bent portion 10212 and the blocking portion 10213 of the first baffle 1021, or the bent portion 10212 and the blocking portion 10213 may be connected through a curved surface. This is not limited in this application. Because the blocking portion 10213 is a structure that is of the first baffle 1021 and that is configured to control a flowing direction of air, that the first baffle 1021 and the second baffle 1022 are disposed perpendicular to each other may be understood as that the blocking portion 10213 and the second baffle 1022 are disposed perpendicular to each other.

In addition, in the inverter 1 provided in this application, in addition to the foregoing disposing manner, the first baffle 1021 may alternatively be disposed in another possible manner, so that the passage that gradually narrows along a flowing direction of air is formed in the first installation cavity 1011a. For example, the first baffle 1021 may be of a flat structure. In this case, one end of the first baffle 1021 may abut against the housing of the fan 1023, and the first baffle 1021 may tilt along a direction that faces away from the first side wall 1012a, provided that a largest spacing between the fan 1023 and the first side wall 1012a can be less than or equal to a smallest spacing between the first baffle 1021 and the first side wall 1012a so that the passage that gradually narrows along a flowing direction of air is formed in the first installation cavity 1011a. This is not listed one by one herein, but should be understood as falling within the protection scope of this application.

Still refer to FIG. 3. In the inverter 1 provided in this embodiment of this application, a projection of the air outlet 10232 of the fan 1023 onto the first side wall 1012a may cover projections of the other part of power devices in the plurality of power devices disposed in the second installation cavity 1011b onto the first side wall 1012a. In this way, air blown out of the air outlet 10232 of the fan 1023 can flow through the other part of power devices in the second installation cavity 1011b to a greater extent, to help improve heat dissipation efficiency of each power device in the second installation cavity 1011b. This helps improve heat dissipation efficiency of the inverter 1.

In the inverter 1 provided in this embodiment of this application, a fastening bracket of the fan 1023 may be fastened to the first side wall 1012a of the chassis 101, to fasten the fan 1023 to the chassis 101. In this case, in this embodiment of this application, a position of the partition and blocking assembly 102 may be limited by using the fastening bracket of the fan 1023. During specific implementation, at least one of the two baffles of the partition and blocking assembly 102 may be fastened to the fastening bracket of the fan 1023 in a manner such as welding, threading, snap-fitting, or the like, to improve structural reliability of the inverter 1. Alternatively, at least one of the two baffles of the partition and blocking assembly 102 and the fastening bracket of the fan 1023 are of an integral structure. This helps improve an integration level of the inverter 1. Alternatively, the two baffles are only in contact with the fastening bracket of the fan 1023, and an acting force may or may not exist between the baffle and the fastening bracket, to improve flexibility of disposing of the partition and blocking assembly 102. In other words, in this embodiment of this application, a connection relationship may or may not exist between the two baffles of the partition and blocking assembly 102 and the fan 1023, provided that the two baffles of the partition and blocking assembly 102 can control a flowing direction of air.

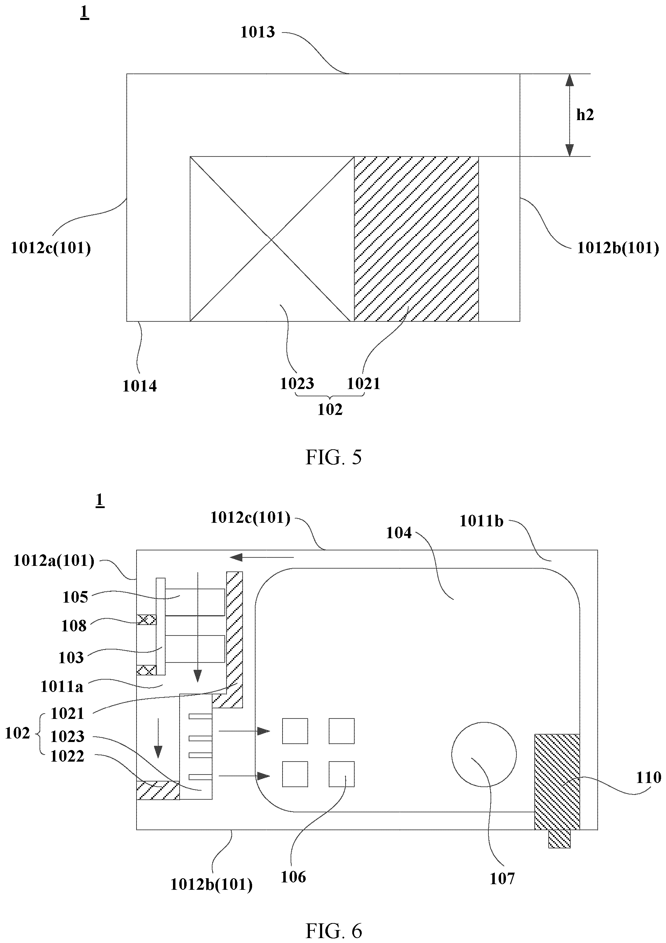

FIG. 5 is a simple diagram of another structure of an inverter 1 according to an embodiment of this application, and may be used to display a view of the inverter 1 along the X direction. In this application, the fan 1023 may alternatively be disposed on the bottom wall 1014 of the chassis 101. In this case, the housing of the fan 1023 may abut against the bottom wall 1014. This may improve reliability of a connection between the fan 1023 and the chassis 101.

In addition, still refer to FIG. 5. In the inverter 1 provided in this embodiment of this application, a largest spacing h2 between the partition and blocking assembly 102 and the top wall 1013 is less than or equal to a second spacing threshold, where the second spacing threshold may be specifically set based on a specific heat dissipation requirement of the inverter 1, a layout of the cavity of chassis 101, and the like. Adoption of this design helps air in the first installation cavity 1011a to flow to the second installation cavity 1011b through the fan 1023, and helps air in the second installation cavity 1011b to flow back to the first installation cavity 1011a through the gap 10111 between the partition and blocking assembly 102 and the second side wall 1012b or through the through hole 10211 of the partition and blocking assembly 102, so that a directional airflow passage can be formed in the cavity of the chassis 101. This helps improve circulation efficiency of air in the cavity of the chassis 101, to improve heat dissipation efficiency of the inverter 1.

In a possible embodiment of this application, a spacing between the first baffle and the top wall 1013 may be further greater than or equal to a spacing between the fan 1023 and the top wall, and the spacing between the first baffle and the top wall 1013 is greater than or equal to a spacing between the first circuit board and the top wall. This facilitates directional airflow in the cavity of the chassis 101, to help improve heat dissipation efficiency of the inverter 1.

It should be noted that, in the foregoing embodiment of this application, the two baffles of the partition and blocking assembly 102 may be two independent plate structures, to improve flexibility of disposing of the two baffles, and help reduce sizes of the two baffles. This helps reduce space occupied by the partition and blocking assembly 102 in the cavity of the chassis 101, to improve space utilization of the cavity of the chassis 101.

In some other possible embodiments of this application, the partition and blocking assembly 102 may alternatively be of an integral structure. In this case, the first baffle 1021 and the second baffle 1022 may be two bent portions formed after a same plate structure is bent. This helps improve structural reliability of the partition and blocking assembly 102. It may be understood that, in this embodiment, one baffle of the partition and blocking assembly 102 may be provided with a through hole, so that the air inlet 10231 of the fan 1023 can communicate with the first installation cavity 1011a. For example, the through hole is provided on the second baffle 1022, so that the fan 1023 communicates with the first installation cavity 1011a through the through hole. Other structures of the partition and blocking assembly 102 and the fan 1023 may be disposed with reference to the foregoing embodiments. This is not described herein again.

According to the foregoing description of the inverter 1 shown in FIG. 3, the partition and blocking assembly 102 and the first side wall 1012a and the second side wall 1012b of the chassis 101 enclose the first installation cavity 1011a, where the second baffle 1022 abuts against the first side wall 1012a, and the end that is of the first baffle 1021 and that is away from the fan 1023 and the second side wall 1012b are spaced, so that the gap 10111 is formed between the first baffle 1021 and the second side wall 1012b. In this case, when the fan 1023 runs, air in the cavity of the chassis 101 may circulate clockwise.

The first baffle 1021 and the second baffle 1022 may control a flowing direction of air, to implement air circulation between the first installation cavity 1011a and the second installation cavity 1011b. Based on this, it may be understood that, in the inverter 1 provided in this embodiment of this application, positions of the first baffle 1021 and the second baffle 1022 are adjusted, so that a circulation path of airflow may be adjusted. For example, in an inverter 1 shown in FIG. 6, the second baffle 1022 still abuts against the first side wall 1012a, the end that is of the first baffle 1021 and that is away from the fan 1023 and the third side wall 1012c are spaced, the third side wall 1012c is another side wall disposed adjacent to the first side wall 1012a, and the second side wall 1012b, the first side wall 1012a, and the third side wall 1012c are sequentially connected. In this case, when the fan 1023 runs, air in the cavity of the chassis 101 may circulate counterclockwise.

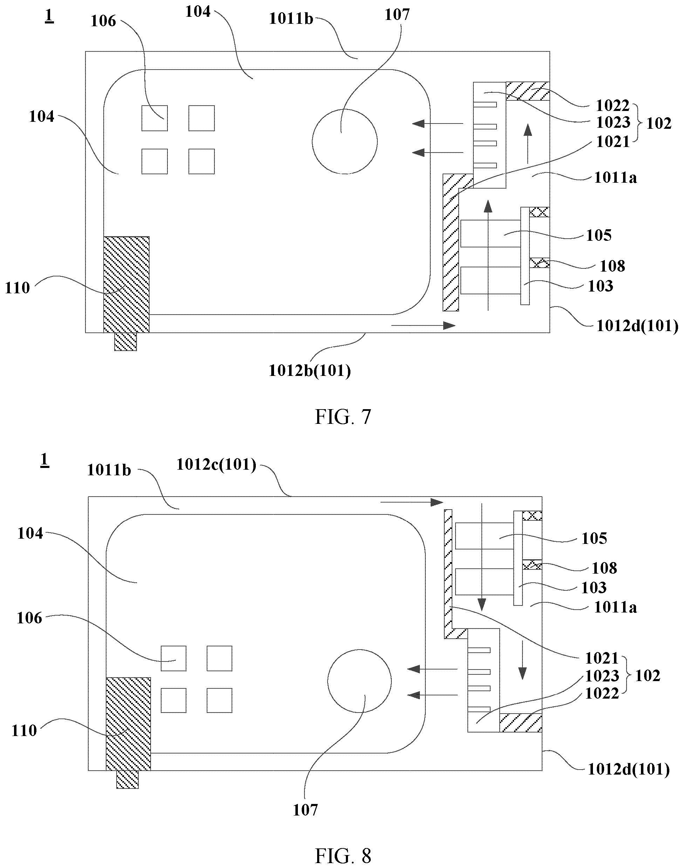

For another example, in an inverter 1 shown in FIG. 7, the partition and blocking assembly 102 and the second side wall 1012b and the fourth side wall 1012d of the chassis 101 enclose the first installation cavity 1011a, and the fourth side wall 1012d and the first side wall 1012a are disposed opposite to each other. In addition, the second baffle 1022 abuts against the fourth side wall 1012d, and the end that is of the first baffle 1021 and that is away from the fan 1023 and the second side wall 1012b are spaced. In this case, when the fan 1023 runs, air in the cavity of the chassis 101 may circulate counterclockwise.

For another example, in an inverter 1 shown in FIG. 8, the partition and blocking assembly 102 and the second side wall 1012b and the fourth side wall 1012d of the chassis 101 enclose the first installation cavity 1011a, the second baffle 1022 still abuts against the fourth side wall 1012d, and the end that is of the first baffle 1021 and that is away from the fan 1023 and the third side wall 1012c are spaced. In this case, when the fan 1023 runs, air in the cavity of the chassis 101 may circulate clockwise.

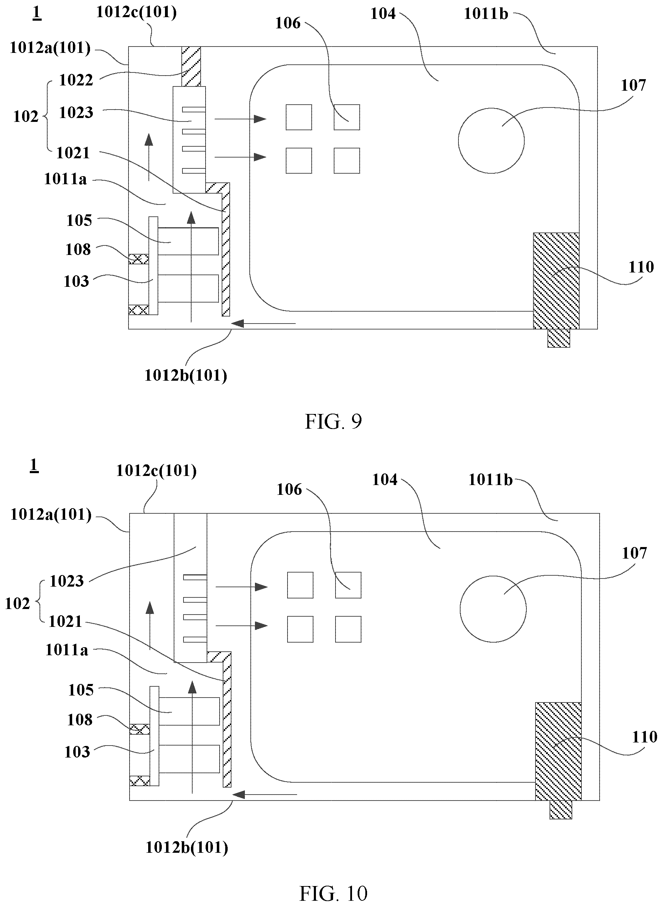

In the inverters 1 shown in FIG. 3 to FIG. 8, an example in which the first baffle 1021 and the second baffle 1022 are disposed perpendicular to each other is used to describe a structure of the partition and blocking assembly 102. In addition, in an inverter 1 shown in FIG. 9, the first baffle 1021 and the second baffle 1022 of the partition and blocking assembly 102 may alternatively be disposed in parallel. In this case, the partition and blocking assembly 102 and the first side wall 1012a, the second side wall 1012b, and the third side wall 1012c that are of the chassis 101 and that are sequentially connected enclose the first installation cavity 1011a, where the end that is of the second baffle 1022 and that faces away from the fan 1023 abuts against the third side wall 1012c, and the end that is of the first baffle 1021 and that is away from the fan 1023 and the second side wall 1012b are spaced. In this case, when the fan 1023 runs, air in the cavity of the chassis 101 may circulate clockwise.

In addition, when the first baffle 1021 and the second baffle 1022 are disposed in parallel, sizes of the first baffle 1021 and the second baffle 1022 may be adjusted, to adjust a position of the fan 1023 relative to each power device in the second installation cavity 1011b, so that air blown out of the air outlet 10232 of the fan 1023 can flow through all power devices in the second installation cavity 1011b to a greater extent. This helps improve heat dissipation efficiency of each power device in the second installation cavity 1011b, to help improve heat dissipation efficiency of the inverter 1.

It should be noted that when the first baffle 1021 includes the bent portion 10212 and the blocking portion 10213, because the blocking portion 10213 is a structure that is of the first baffle 1021 and that is configured to control a flowing direction of air, that the first baffle 1021 and the second baffle 1022 are disposed in parallel may be understood as that the blocking portion 10213 and the second baffle 1022 are disposed in parallel.

In addition, the first baffle 1021 and the second baffle 1022 are not limited to be disposed perpendicular to each other or in parallel. For example, when the first baffle 1021 and the first side wall 1012a are disposed opposite to each other, an included angle between the second baffle 1022 and the first side wall 1012a in a counterclockwise direction may be greater than or equal to 90° and less than or equal to 180°, so that the included angle between the second baffle 1022 and the first baffle 1021 in the counterclockwise direction is greater than or equal to 0° and less than or equal to 90°. This may be specifically disposed based on an internal layout of the cavity of the chassis 101 of the inverter 1, to improve flexibility of disposing of the partition and blocking assembly 102.

In the foregoing embodiments of this application, an example in which the partition and blocking assembly 102 includes two baffles is used to describe an implementation in which a circulation air duct is formed in the cavity of the chassis 101 of the inverter 1. However, in another possible embodiment of this application, the partition and blocking assembly 102 may alternatively include only one baffle, and may also form a circulation air duct in the cavity of the chassis 101 of the inverter 1. For example, FIG. 10 is a simple diagram of another structure of an inverter according to an embodiment of this application. In an inverter 1 shown in FIG. 10, the housing of the fan 1023 abuts against the third side wall 1012c of the chassis 101. In addition, the partition and blocking assembly 102 includes the first baffle 1021, the first baffle 1021 and the first side wall 1012a are disposed opposite to each other, and the first baffle 1021 abuts against the housing of the fan 1023. In this way, the third side wall 1012c of the chassis 101 and the first baffle 1021 may jointly control a flowing direction of air, so that air circulates between the two installation cavities.

The inverters 1 shown in FIG. 3 to FIG. 10 are merely several examples of specific disposing manners of the partition and blocking assembly 102 in the inverter 1 provided in embodiments of this application. In actual application, a quantity of baffles, a disposing position, and the like of the partition and blocking assembly 102 may be properly adjusted based on a specific layout requirement of the cavity of the chassis 101. This is not described herein one by one, but should be understood as falling within the protection scope of this application.

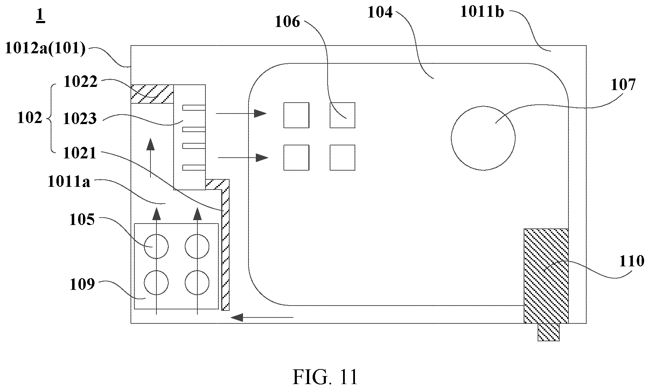

In addition, in the foregoing embodiments, an example in which the first circuit board 103 that is of the inverter 1 and that is for disposing the part of power devices in the first installation cavity 1011a and the first side wall 1012a are disposed in parallel is used to describe a structure of the inverter 1. In this embodiment of this application, the circuit board for disposing the part of power devices in the first installation cavity 1011a and the first side wall 1012a may alternatively be disposed at another angle. For example, an inverter 1 shown in FIG. 11 may include a second circuit board 109, and the second circuit board 109 and the first side wall 1012a are disposed perpendicular to each other. The second circuit board 109 may be fastened to the bottom wall of the chassis 101. In addition, the second circuit board 109 is located between the first side wall 1012a and the first baffle 1021, and the part of power devices are disposed on the second circuit board 109. This may help reduce the spacing between the first side wall 1012a and the first baffle 1021, to help reduce the volume of the first installation cavity 1011a, so that a flowing speed of air in the first installation cavity 1011a is improved, to improve heat dissipation efficiency of the part of power devices. In addition, another structure of the inverter 1 shown in FIG. 11 may be disposed with reference to any one of the foregoing embodiments, and details are not described herein again.

In addition to the foregoing structure, the inverter 1 provided in this application may further include a direct current switch 110. In the inverters 1 shown in FIG. 3 to FIG. 11, the direct current switch 110 and the partition and blocking assembly 102 are located on two opposite sides of the cavity of the chassis 101. The direct current switch 110 may be electrically connected to the third circuit board 104, and specifically, a processor may be disposed on the third circuit board 104. In this case, the direct current switch 110 may be electrically connected to the processor, to control the switching on and switching off of the direct current switch 110.

It may be understood that a disposing position of the direct current switch 110 is not limited to the foregoing description, and this may be properly disposed based on a specific layout requirement of the cavity of the chassis 101.

In the inverter 1 provided in this embodiment of this application, the cavity of the chassis 101 is divided into two communicating installation cavities through the partition and blocking assembly 102, so that the plurality of power devices of the inverter 1 may be disposed in the two installation cavities. In this way, a flowing direction of air can be controlled through the partition and blocking assembly 102, so that air can circulate between the two installation cavities. In this case, in the inverter 1, one fan 1023 is disposed, so that heat dissipation of the power devices disposed on different circuit boards and the cavity of the chassis 101 can be implemented. This can reduce the size of the inverter 1 when a heat dissipation requirement of the inverter 1 is met, to facilitate transportation and installation of the inverter 1. When the inverter 1 is used in a photovoltaic energy storage system, costs of the photovoltaic energy storage system can be reduced.

It should be understood that, in embodiments of this application, the power device in the first installation cavity 1011a is not limited to the electrolytic capacitor 105 mentioned above, and may alternatively be a power device such as the inductor 107 or the relay 106. In addition, a quantity of circuit boards in the first installation cavity 1011a is not limited to one, and a quantity of circuit boards in the second installation cavity 1011b is not limited to one either. The foregoing structures may be adaptively adjusted based on an actual application requirement, and should be understood as falling within the protection scope of this application. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An inverter, comprising a plurality of power devices, a chassis, and a partition and blocking assembly, wherein the plurality of power devices and the partition and blocking assembly are accommodated in a cavity of the chassis;
the partition and blocking assembly divides the cavity of the chassis into a first installation cavity and a second installation cavity, a volume of the first installation cavity is less than a volume of the second installation cavity, a part of power devices in the plurality of power devices are disposed in the first installation cavity, and the other part of power devices in the plurality of power devices are disposed in the second installation cavity; and
the chassis comprises a first side wall and a second side wall that are adjacent to each other, the partition and blocking assembly comprises a fan, an air inlet of the fan communicates with the first installation cavity, and an air outlet of the fan communicates with the second installation cavity; a direction from the air inlet to the air outlet faces away from the first side wall; and a gap exists between the partition and blocking assembly and the second side wall, or the partition and blocking assembly is provided with a through hole.

2. The inverter according to claim 1, wherein the partition and blocking assembly further comprises a first baffle and a second baffle, the first baffle and the second baffle are respectively disposed at two opposite ends of a housing of the fan, and the first baffle and the second baffle abut against the housing of the fan.

3. The inverter according to claim 2, wherein the first baffle and the first side wall are disposed opposite to each other, and an included angle between the second baffle and the first side wall in a counterclockwise direction is greater than or equal to 90° and less than or equal to 180°.

4. The inverter according to claim 3, wherein the first baffle and the second baffle are disposed perpendicular to each other, or the first baffle and the second baffle are disposed in parallel.

5. The inverter according to claim 3 or 4, wherein the chassis further comprises a third side wall, the second side wall, the first side wall, and the third side wall are sequentially connected, and the second side wall and the third side wall are disposed opposite to each other; and the first baffle and the second baffle are disposed perpendicular to each other, and an end that is of the second baffle and that faces away from the fan abuts against the first side wall; or the first baffle and the second baffle are disposed in parallel, and an end that is of the second baffle and that faces away from the fan abuts against the third side wall.

6. The inverter according to claim 1, wherein the chassis further comprises a third side wall, the second side wall, the first side wall, and the third side wall are sequentially connected, and the second side wall and the third side wall are disposed opposite to each other; and
the partition and blocking assembly comprises a first baffle, the first baffle and the first side wall are disposed opposite to each other, a housing of the fan abuts against the third side wall, and the first baffle abuts against the housing of the fan.

7. The inverter according to any one of claims 2 to 6, wherein the gap exists between the partition and blocking assembly and the second side wall, and the gap is located between the second side wall and an end that is of the first baffle and that faces away from the fan.

8. The inverter according to any one of claims 2 to 6, wherein the partition and blocking assembly is provided with the through hole, and the through hole is provided on the first baffle.

9. The inverter according to any one of claims 2 to 8, wherein a projection of the first baffle onto the first side wall covers projections of the part of power devices onto the first side wall.

10. The inverter according to claim 9, wherein the inverter further comprises a first circuit board, the first circuit board and the first side wall are disposed in parallel, and the part of power devices are disposed on a side that is of the first circuit board and that faces the first baffle.

11. The inverter according to claim 9, wherein the inverter further comprises a second circuit board, the second circuit board and the first side wall are disposed perpendicular to each other, the second circuit board is located between the first side wall and the first baffle, and the part of power devices are disposed on the second circuit board.

12. The inverter according to any one of claims 9 to 11, wherein a largest spacing between the part of power devices and the first baffle is less than or equal to a first spacing threshold.

13. The inverter according to any one of claims 2 to 12, wherein a largest spacing between the fan and the first side wall is less than or equal to a smallest spacing between the first baffle and the first side wall.

14. The inverter according to claim 13, wherein the first baffle comprises a bent portion and a blocking portion that are connected, the blocking portion and the first side wall are disposed opposite to each other, the bent portion extends along a direction from the blocking portion to the first side wall, and an end that is of the bent portion and that faces away from the blocking portion abuts against the housing of the fan.

15. The inverter according to any one of claims 1 to 14, wherein a projection of the air outlet of the fan onto the first side wall covers projections of the other part of power devices onto the first side wall.
